(19) Europäisches Patentamt
European Patent Office
Office européen des brevets

(11) **EP 2 309 459 A1**

(12) **EUROPEAN PATENT APPLICATION**

(43) Date of publication:
**13.04.2011 Bulletin 2011/15**

(51) Int Cl.:
*G06T 11/00* (2006.01)     *H01J 37/22* (2006.01)

(21) Application number: **09170779.4**

(22) Date of filing: **20.09.2009**

| | |
|---|---|
| (84) Designated Contracting States:<br>**AT BE BG CH CY CZ DE DK EE ES FI FR GB GR HR HU IE IS IT LI LT LU LV MC MK MT NL NO PL PT RO SE SI SK SM TR**<br>Designated Extension States:<br>**AL BA RS**<br><br>(71) Applicant: **Universiteit Antwerpen**<br>**2000 Antwerpen (BE)** | (72) Inventor: **Van Dyck, Dirk**<br>**2630 Aartselaar (BE)**<br><br>(74) Representative: **Wauters, Davy Erik Angelo**<br>**DenK IP bvba**<br>**Pastoor Ceulemansstraat 3**<br>**3191 Schiplaken (Hever) (BE)** |

(54)     **Methods and systems for tomographic reconstruction of coherent radiation images**

(57)     A method and system are described for reconstructing a coherent radiation tomographic image of at least one object. The method comprises performing back-projection, whereby performing back-projection comprises taking into account propagation waves from the point of interaction to a plane of detection. Furthermore a method is described for studying objects, wherein a plurality of objects are imaged on a substrate using coherent radiation tomography and whereby the method as described above is used for characterizing the objects.

FIG. 8

**Description**

**Field of the invention**

The invention relates to the field of reconstruction in tomography. More particularly, the present invention relates to methods and systems for reconstruction of small objects in tomography, such as for example reconstruction of proteins in x-ray or electron microscopy tomography.

**Background of the invention**

In the quest for the full understanding of life processes at the cellular level, high resolution biological imaging plays an important role. Many proteins are considered modules that are used a multiple of times in the formation of different complexes. For most of the complexes the function is as yet unknown. However it is thought that they participate in key processes in the living cell and that an understanding of the structure and the dynamics of the constituent proteins is required as a necessary step towards a full understanding of life processes at the cellular level. The large size of the complexes formed in multiple associations and their likely dynamical variability in the functional context takes most of these complexes out of the reach of X-ray crystallography and leaves Cryo-electron microscopy as one of the few techniques of structural investigation. Single particle techniques in particular are preferred since they leave molecular interactions constrained.

Radiation damage has always appeared to set the ultimate limit of the resolution in biological imaging. Many ingenious techniques have been developed to circumvent this barrier, the most successful of them taking advantage of redundancy, either crystallographic or artificial as in cryo electron microscopy. For the imaging of individual biological structures a recent survey of measurements against dose suggests that dose varies as the inverse fourth power of resolution for X-ray tomography so that the damage penalty for small resolution improvements is severe indeed.

Since the ultimate resolution limit in individual biological structures with X-rays as well as with electrons is about 10 nm the only way to improve the resolution so as to resolve individual atoms is by averaging a multitude of identical particles in the order of 1 million or more. In X-ray diffraction this is achieved by the redundancy of many identical unit cells. But in single particle cryo-EM this is much more difficult since the particles are suspended on a thin support film in different orientations. In order to solve this problem advanced multivariate techniques are used to classify and average the different projections and then recombine them to a consistent 3D model. Thus far this method only works if the macro-molecular assemblies are large enough (> 1M Dalton) to recognise specific characteristics and care has been taken to avoid problems of uniqueness (handedness).Moreover the support film also adds spurious details to the contrast. Despite these difficulties cryo-EM had been pushed to the level where already several large macromolecular structures (e.g ribosome) have been resolved to a resolution below 1 nm that is sufficient to recognise the shape of smaller protein subunits that have already been determined by X-ray crystallography. However there is still a very large fraction (more than 90%) of the proteins that fall in the gap between the possibilities of X-ray diffraction and single particle EM.

One of the solutions explored is the use of diffractive imaging with femto-second X-ray pulses from a next generation free electron laser. It is believed that a very short X-ray pulse can diffract at the object before it is destroyed and that the biological structure can then be retrieved from the diffraction pattern using computational hybrid input-output (HIO) methods. Nevertheless, the solution has not been experimentally established yet.

**Summary of the invention**

It is an object of embodiments of the present invention to provide good methods and systems for reconstructing objects in coherent radiation tomography applications. It is an advantage of embodiments according to the present invention that accurate reconstruction can be obtained allowing 3D combination of projections of individual particles imaged together for which the orientation is not known when imaged. It is an advantage of embodiments according to the present invention that the method can be applied to coherent wave tomography applications such as x-ray tomography and advantageously also to electron tomography. It is an advantage of embodiments according to the present invention that the methods and systems can take into account multiple scattering. The above objective is accomplished by a method and device according to the present invention.

The present invention relates to a method for reconstructing a coherent radiation tomographic image of at least one object, advantageously a plurality of objects, the method comprising performing back-projecting, whereby said performing back-projecting comprises taking into account propagation waves from the interaction volume to a detection surface. It is an advantage of embodiments according to the present invention that propagation of waves, i.e. amplitudes and phases, is used for said reconstruction rather than reconstruction based on images, resulting in the possibility of reconstructing coherent radiation tomographic images, such as x-ray tomographic images or electron microscopy tomographic images without being limited by a defocus effect, e.g. induced by different positions of the at least one object or parts thereof in the interaction region. It is an advantage of embodiments according to the present invention that the concept of exit wave reconstruction is integrated with filtered back projection tomography. The interaction volume may be small. The interaction volume may be considered as interaction point. The detection surface may be a plane of detection.

The method may comprise receiving image wave tomographic data. The image wave tomographic data may comprise X-ray wave tomographic data or electron microscopy wave tomographic data.

The method furthermore may comprise applying a ramp filter for correcting for oversampling of an origin of the object imaged.

Performing back-projecting may comprise Fourier transforming projected image wave tomographic data thus back-propagating from the image plane to the object. Performing back-projecting may comprise sectioning a Fourier space in paraboloids. The method furthermore may comprise applying a Wiener filter for taking into account scattering.

The present invention also relates to a method for studying objects using coherent radiation tomography, the method comprising receiving tomographic data of a substrate with a plurality of identical objects, and applying a method for reconstructing a tomographic image as described above based on the received tomographic data. Receiving tomographic data may comprises receiving the data via an input port or obtaining by acquisition tomographic data of a substrate with a plurality of identical objects, e.g. the objects being oriented in different directions. It is an advantage of embodiments according to the present invention that the method can be applied for high resolution electron tomography of a substrate covered with a plurality of identical particles, e.g. proteins, allowing correction for changing imaging conditions of the different particle at different positions on the substrate.

The tomographic data of the substrate with the plurality of identical objects may comprise data for the substrate being relatively tilted over a range of angles with respect to the radiation used.

The method further may comprise isolating a 3D reconstruction of the particles from the substrate.

The method further may comprise performing cross-correlation of the plurality of reconstructed objects so as to derive individual information of the identical particles under study by averaging. It is an advantage of embodiments according to the present invention that by cross-correlating and/or averaging a number of identical particles in the reconstruction, the resolution of the information, e.g. reconstructed image, obtained can be very good, i.e. down to the Angstrom level, i.e. down to the atomic level.

The method thus may comprise first reconstructing a plurality of objects on the film and thereafter cross-correlating and/or averaging identical particles from the reconstruction. It is an advantage of embodiments according to the present invention that the position and orientation of the objects does not need to be determined before reconstruction.

According to some embodiments, the present invention also relates to a method for studying objects using coherent radiation tomography, wherein the method comprises, for a plurality of identical objects on a film, first reconstructing the plurality of objects and the film and thereafter cross-correlating and/or averaging reconstructed identical particles in the reconstruction. The reconstruction may be a reconstruction according to a method as described above.

The present invention also relates to an image processing system configured for performing a method for reconstructing a coherent radiation tomographic image of at least one object as described above and/or performing a method for studying objects using coherent radiation tomography as described above.

The present invention furthermore relate to a tomography device for performing tomography, the system comprising an image processing system as described above. The present invention also relates to a computer program product for performing, when implemented on a computing device, a method for reconstructing a coherent radiation tomographic image of at least one object as described above and/or performing a method for studying objects using coherent radiation tomography as described above.

The present invention also relates to a machine readable data storage device storing such a computer program product or the transmission of such a computer program product over a local or wide area telecommunications network.

The present invention also relates to the use of a method for reconstructing a coherent radiation tomographic image of at least one object as described above and/or performing a method for studying objects using coherent radiation tomography as described above, for the characterisation of proteins using electron tomography.

Particular and preferred aspects of the invention are set out in the accompanying independent and dependent claims. Features from the dependent claims may be combined with features of the independent claims and with features of other dependent claims as appropriate and not merely as explicitly set out in the claims. These and other aspects of the invention will be apparent from and elucidated with reference to the embodiment(s) described hereinafter.

**Brief description of the drawings**

FIG. 1 illustrates an electron tomography system as could be used for performing a method according embodiments of the present invention

FIG. 2 illustrates different steps of an exemplary method according to an embodiment of the present invention.

FIG. 3 illustrates propagation or back propagation of a wave between object and image plane, as can be used in an embodiments of the present invention.

FIG. 4 illustrates oversampling of an object for a back-propagating method according to an embodiment of the present invention.

FIG. 5 to 7 illustrate basic principles for conventional back projecting methods.

FIG. 8 to 9 illustrates an exemplary method for characterizing objects such as proteins using coherent radiation tomography, according to an embodiment of the present invention.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

**Detailed description of illustrative embodiments**

Whereas in embodiments of the present invention reference is made to the atomic level or Angstrom level, sizes envisaged are in the range of 0.1 to 10 Angstrom, or more preferably in the range of 0.1 to 5 Angstrom even more preferably 0.1 to 3 Angstrom.

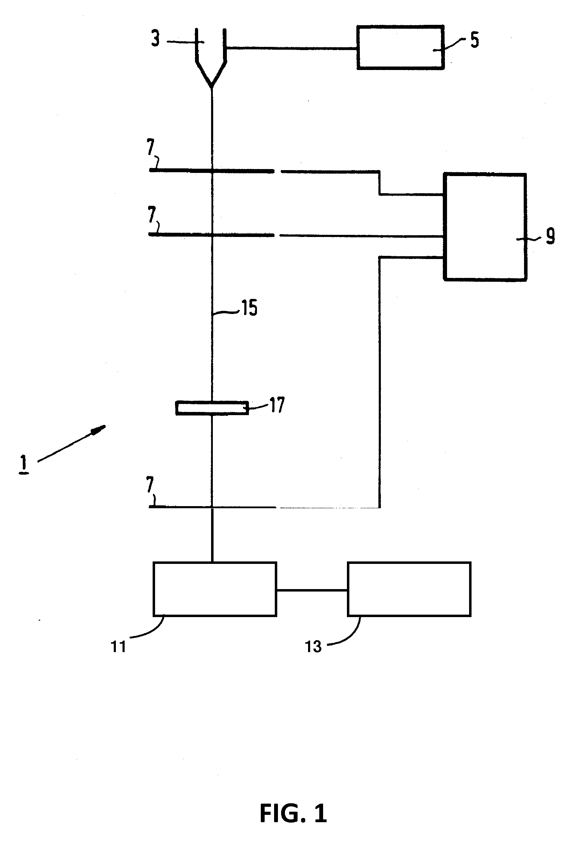

Some embodiments according to the present invention relate to electron tomography, which may be performed in an electron microscope. By way of illustration, a schematic example of an electron microscope that could be used for performing at least part of the methods as described below is shown in FIG. 1, although methods and systems according to embodiments of the present invention are not limited thereby. The high-resolution electron microscope 1, which is diagrammatically shown in FIG. 1 comprises an electron source 3 which is fed by a high-voltage generator 5, and also comprises a number of lenses which are fed by a lens power supply source 9. The electron microscope 1 also comprises a detection system 11, the detected information being applied to an image processing system 13. The electron beam 15 is incident on an object 17. High-resolution images of the object 17 can be recorded in images planes 19 with slightly different defocus values. In one aspect, the present invention also relates to a tomography system comprising an image processing system 13, wherein the image processing system is adapted for performing any of the methods according to the present invention.

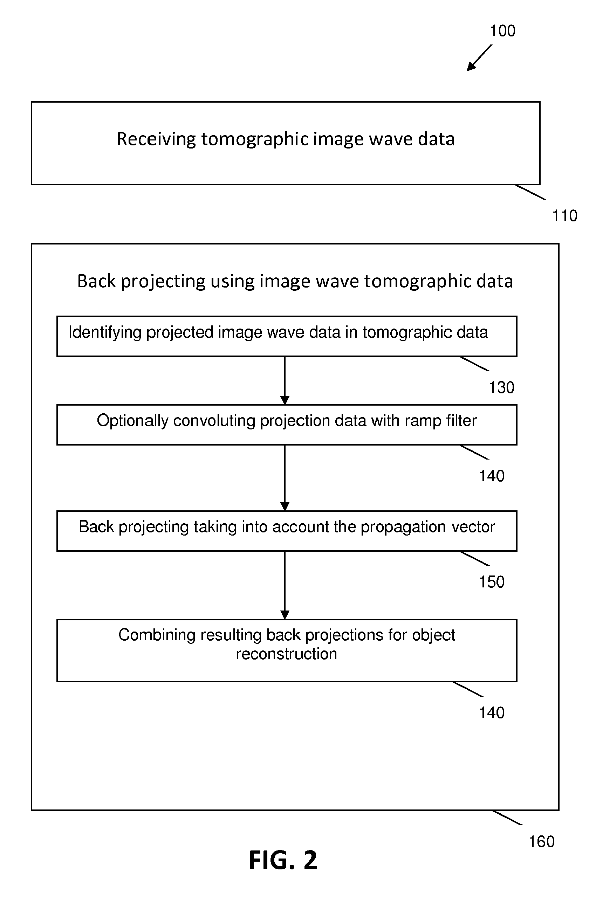

In a first aspect, the present invention relates to a method for reconstructing a coherent radiation tomography image of one or more objects. With coherent radiation tomography, reference is especially made to x-ray tomography and electron tomography, although also other types of tomography such as optical tomography may be envisaged. Tomography thereby may be used to refer to imaging techniques by sectioning through use of energy waves, whereby a tomographic reconstruction allows for deriving an image of the object made. In some advantageous embodiments, reference may be particularly made to electron tomography or x-ray tomography, allowing particular applications. Thus, for some advantageous embodiments although the invention is not limited thereto, radiation may especially refer to radiation that can be described by the Schrödinger equation. The method for reconstructing an image of one or more objects may be applied to all particles suitable for coherent radiation tomographic imaging. The methods may be especially applied to those particles having dimensional properties at the edge of the resolution of the recording system. Methods according to embodiments of the present invention may especially advantageously be applied to biological particles that may suffer from radiation damage if a too high radiation intensity is used. Examples of such biological particles are proteins. Nevertheless, other objects such as for example nanoparticle like quantum dots, catalytic particles, etc. also are envisaged. In embodiments of the present invention, the method comprises performing filtered back-projecting comprising propagating waves from the point of interaction to a plane of detection. The method therefore also may be referred to as filtered back propagating method. The general principles of filtered back-projecting are illustrated below, the invention not being limited thereto. The method may combine exit waves obtained along different projection direction. The method may be especially suitable for being a computer-implemented method. Steps of the method thereby may be made in an automatic and/or automated way, being based for example on a predefined algorithm. Further details and advantages will be described with reference to an exemplary method 200 as shown in FIG. 2, illustrating standard and optional steps of a method for reconstructing, embodiments of the present invention not being limited thereto.

The reconstruction method 100 may comprise in one step 110 receiving image wave tomographic data of the object or objects under study. Such receiving may be receiving, e.g. via an input means, of previously stored and/or converted image wave tomographic data, although the invention is not limited thereto. Receiving also may comprise obtaining image wave tomographic data by recording such data using a tomographic system. The tomographic system thereby may be adapted for producing image wave tomographic data rather than image intensity tomographic data. Obtaining image wave tomographic data may comprise reconstructing an image wave for example by focal series reconstruction, by off axis holography or by using a phase plate.

E.g. based on the received image wave tomographic data of the object or objects, the method comprises applying a back filter projection 120 using image wave tomographic data of the object or objects. The latter may include the following substeps :

In a first sub-step 130, projected image wave data obtained for an object $f(\overline{R})$ are identified in the received tomography data. This data comprises phase and amplitude information rather than intensity information.

In an optional sub-step 140, the identified projected image wave data may be convoluted with a ramp filter to compensate for denser sampling near the origin of the object, so that blurring can be reduced. The latter will be further illustrated in the theoretical description described below.

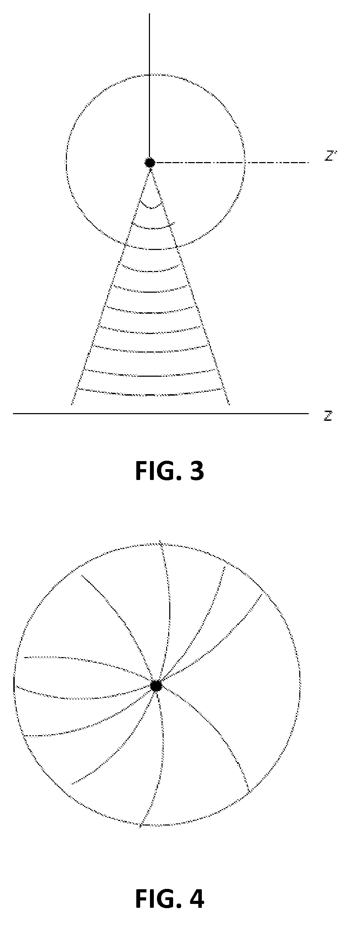

In sub-step 150, the projected image wave data, optionally convoluted with the ramp filter, then is back-projected taking into account a propagation vector of the wave, resulting in contributions of these projections to a reconstructed object, explicitated as paraboloidal sections of the Fourier space. The back projecting may be considered as back propagating the wave from the image plane to the object. By way of illustration, the present invention not being limited thereto, the propagation from a point of the object z' to a point in the image z, for which back propagation is performed using back-projection taking into account the propagation vector, is shown in FIG. 3. The paraboloidal sampling is shown in FIG. 4.

In sub-step 160, the different paraboloidal sections may be combined allowing reconstruction of the Fourier space, or in other words reconstruction of the object imaged.

The different steps described above will be illustrated in detail in an exemplary theoretical description of the algorithm used.

In one particular embodiment, where the reconstruction method is applied to protein tomography or other tomography where most constituent atoms are in a small range of z-values, the 3D wave in Fourier space is multiplied with a kind of "average" scattering factor. Correction then may be performed by deconvoluting with this factor. For example in case of protein tomography, most constituent atoms (except H) are in the range z = 6 to 8. By deconvoluting with this factor, using a type of Wiener filter to suppress the noise, one can sharpen up the tomographic reconstructions. This can be done, e.g. in the case of filtered back projection by combining the ramp filter with this Wiener filter.

In another particular embodiment, apart from correction for the defocus effect, the image waves obtained in the receiving step also can be corrected for other coherent aberrations such as the spherical aberration. It would be useful to dispose of a Cs corrected imaging system such as an electron microscope to keep the delocalisation of the images minimal and to extend the area of observation, as aberration may blur the images so that they widen and a larger field of view would be required for obtaining the same information.

As the back propagation method according to embodiments of the present invention makes use of the distance to a reference point, e.g. the center of the object, advantageously accurate knowledge of these distances should be obtained. Advantageously, tight mechanical control of the tomographic equipment may be available.

In some particular embodiments, methods also may comprise the additional feature of taking into account multiple scattering in an object. Although multiple scattering in some objects, such as for example proteins, may be of less importance than in other objects, e.g. crystals where all the atoms in a column are aligned, the effect of multiple scattering may be not negligible. As the tomographic scheme reinforces the linear contribution in a consistent way whereas the nonlinear effects will vary more at random the ratio linear/nonlinear will be increased with increasing number of projections. Other examples where linear/nonlinear contributions are enhanced are the linearisation of an exit wave for a series of high resolution images, precession electron diffraction or averaging diffraction intensities in LEED. In this way, methods according to embodiments of the present invention can be easily extended to take into account multiple scattering.

Without wishing to be bound by theory, features and advantages of some embodiments of the present invention could be explained based on the following theoretical principles and algorithm, embodiments of the present invention not being limited thereto. For this illustrative description, reference is made to electron tomography, embodiments of the present invention not being limited thereto. The algorithm is expressed using a particular mathematical formulation, but it is to be noticed that other mathematical representations also could be used for illustrating the algorithm, embodiments of he present invention not being limited thereby. According to the example, the method for reconstructing can be based on a wave reconstruction algorithm, which is a filtered back projection algorithm with integrated exit wave algorithm. The conventional filtered back projection algorithm is based on the projection theorem, also referred to as the Fourier slice theorem :

If a function f(r) is considered that describes a local property (e.g. mass density) of an object. The Fourier transform then yields

$$f(\overline{r}) = \iint F(\overline{g}) e^{2\pi i \overline{g} \cdot \overline{r}} d\overline{g} \qquad\qquad [1]$$

Decomposing can be done

$$\bar{r} = \left(\overline{R}, z\right) \qquad [2]$$

$$\bar{g} = \left(\overline{G}, w\right) \qquad [3]$$

$$\bar{g}.\bar{r} = \overline{G}.\overline{R} + w.z \qquad [4]$$

with z along the direction of the projection and G perpendicular to it.

Projection along the z-axis yields

$$f_p\left(\overline{R}\right) = \int_{-\infty}^{+\infty} f\left(\overline{R}, z\right) dz \qquad [5]$$

$$f_p\left(\overline{R}\right) = \iint e^{2\pi i \overline{G}.\overline{R}} F\left(\overline{G}, w\right) d\overline{G}\, dw \int_{-\infty}^{+\infty} e^{2\pi i z w} dz \qquad [6]$$

and since

$$\int_{-\infty}^{+\infty} e^{2\pi i z w} dz = \delta(w) \qquad [7]$$

one has

$$f_p\left(\overline{R}\right) = \int e^{2\pi i \overline{G}.\overline{R}} d\overline{G} \int F\left(\overline{G}, w\right) \delta(w) dw \qquad [8]$$

Using the sift property of the delta function the following equation is obtained

$$f_p\left(\overline{R}\right) = \int F\left(\overline{G}, 0\right) e^{2\pi i \overline{G}.\overline{R}} d\overline{G} \qquad [9]$$

In conclusion, according to the projection theorem, the Fourier transform of the projection of an object yields a planar section through the origin in Fourier space, which is perpendicular to the direction of the projection. Since this planar section is infinitely thin in the w direction the Fourier transform of this section back to real space then corresponds to smearing out the projected signal $f_p(\overline{R})$ homogeneously along the z direction. The latter is the bases for back projection.

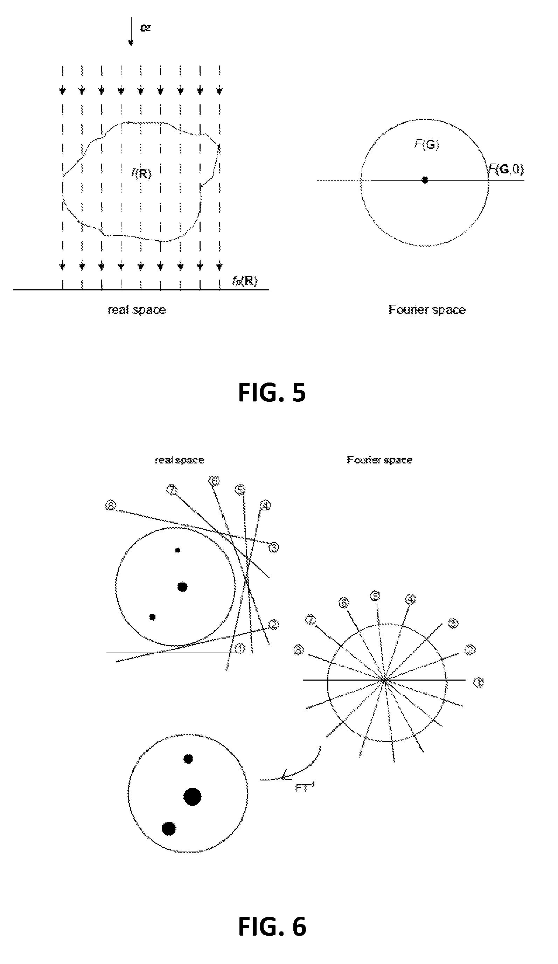

Also a different description of the filtered back projection algorithm can be provided which avoids using the classical sinograms and which is more intuitive and suitable to serve as theoretical description for the filtered back projection algorithm as used in embodiments according to the present invention. If an object $f(\overline{R})$ is projected along different directions, each projection, when Fourier transformed, yields a section through Fourier space. If the number of projections is sufficient, Fourier space is adequately sampled. Fourier transforming back then enables to reconstruct *f* (*r̄*) in real space, as is illustrated in FIG. 5. This can be done section by section in which the projected signal of each section is back projected in real space.

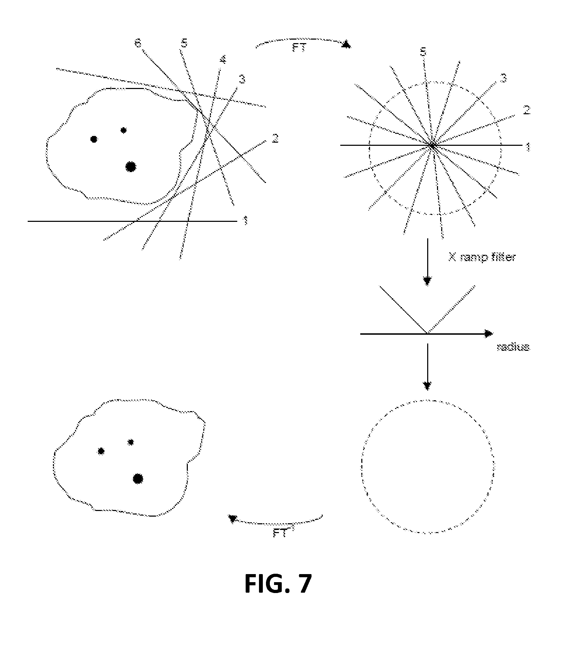

However, as seen in FIG. 6, the central part of Fourier space is more closely sampled. The sampling density is proportional to the distance from the origin. This denser sampling has an equivalent effect as a low pass filter, which will blur the reconstructed object *f(R̄)*. In order to compensate for this, one can apply an inverse filter, which multiplies Fourier space with a radial weight factor proportional to the distance from the origin. This is called a ramp filter. Applying this ramp filter before Fourier transforming to real space, will undo the blurring and reconstruct the true *f(R̄)*. This process is therefore called filtered back projection and is shown in FIG. 7. The filtering and backprojection can also be done section by section in real space by convoluting the projected signal in a section with a filter that is the Fourier transform of the ramp filter, followed by back projection. Summarising, each projected plane *f_p(R̄)* is first convoluted with the 2D Fourier transform of the 2D ramp filter and then backprojected homogeneously along the z direction. This process is repeated for all projection directions.

Turning now to examples of embodiments of the present invention, illustrated for electron microscopy. A plane wave along the z direction which scatters at an object is considered. Starting from the usual high-energy diffraction equation which can be deduced from the Schrödinger equation neglecting backscattering in the object

$$\frac{\delta\psi}{\delta z} = i(\Delta + V)\psi \qquad [10]$$

where Ψ is the electron wave, $\Delta = \dfrac{\Delta xy}{4\pi k}$ with k the incident wave vector and Δxy the Laplacean operator in the xy plane perpendicular to the incident beam direction. It describes the transversal kinetic energy, $V = \dfrac{eV(\bar{r})}{4\pi k}$ with V (*r̄*)the electrostatic crystal potential and e the electron charge, Ψ(0) is the incident wave, in case of HREM Ψ(0) = 1. In the kinematical (single scattering) approximation the electron wave at a particular position z is given by

$$\psi(\overline{R}, z) = 1 + i\int e^{i\Delta(z-z')}V(\overline{R}, z')dz' \qquad [11]$$

*V(R̄,z')*represents the probability amplitude that the incident wave interacts with the potential at (*R̄,z'*) and *e^{iΔ(z-z')}* is the propagation operator describing the propagation of the electron in free space from z' to z, as illustrated in FIG. 3. If one would neglect the effect of the propagator, the electron wave is simply the projection of the electrostatic potential. By subtracting 1 (non-interacting) wave, one obtains what is called the object wave, which contains the information about the object.

The tomographic reconstruction scheme then could be derived as follows : Fourier transforming the object wave with respect to *R̄* results in

$$\psi(\overline{G}, z) = \int e^{i\frac{\lambda G^2}{2}(z-z')}V(\overline{G}, z')dz' \qquad [12]$$

One can now further Fourier transform *V(R̄, z')* with respect to z'

$$V(\overline{G}, z') = \int V(\overline{G}, w)e^{2\pi i w z'}dw \qquad [13]$$

so that

$$\psi\left(\overline{G},z\right)=e^{i\frac{\lambda G^2}{2}z}\int V(\overline{G},w)dw\int e^{2\pi iz'(w-\frac{\lambda G^2}{2})}dz' \qquad [14]$$

$$\psi\left(\overline{G},z\right)=e^{i\frac{\lambda G^2}{2}z}\int V(\overline{G},w)dw\delta(w-\frac{\lambda G^2}{2}) \qquad [15]$$

$$\psi\left(\overline{G},z\right)=e^{i\frac{\lambda G^2}{2}z}V(\overline{G},\frac{\lambda G^2}{2}) \qquad [16]$$

or

$$e^{-i\frac{\lambda G^2}{2}}\psi\left(\overline{G},z\right)=V(\overline{G},\frac{\lambda G^2}{2}) . \qquad [17]$$

represents a paraboloidal section through the Fourier transform of the potential. This means that, in method embodiments according to the present invention, the usual Fourier slice theorem is replaced by a Fourier paraboloidal slice theorem. If this procedure is repeated from different viewing directions, the Fourier space is cut in paraboloidal sections through the origin of the shape

$$w=\frac{\lambda G^2}{2} \qquad [18]$$

Note that this paraboloid is in fact the quadratic approximation of the Ewald sphere which reflects the propagation of the electron in free space.

In real space the Fourier transform of

$$e^{-i\frac{\lambda G^2}{2}}\psi\left(\overline{G},z\right)=V(\overline{G},\frac{\lambda G^2}{2}) \qquad [19]$$

with respect to G then yields

$$\tilde{V}\left(\overline{R},z\right)=\int e^{-i\Delta(z-z')}\psi(\overline{R},z)dz' \qquad [20]$$

$\tilde{V}(\overline{R},z)$ is the contribution of this projection to the reconstructed electrostatic potential. By combining a sufficient number of viewing directions, one can then reconstruct Fourier space whereby the conventional back projection has been replaced by

$$\tilde{V}\left(\overline{R},z\right)=\int e^{-i\Delta(z-z')}\psi(\overline{R},z)dz' \qquad [21]$$

where the propagator corrects for the curvature of the paraboloid. In a sense the wave has to be back propagated from the image plane to the object, as illustrated in FIG. 3.

The latter illustrates that according to embodiments of the present invention, the wave function is not simply back projected homogeneously along z but back propagated using the free electron propagation operator. Hence this procedure could be referred to as the Fourier back propagation method.

As is clear from FIG. 4, also in embodiments according to the present invention oversampling of the central area may occur, and therefore a filter may be applied to the back projection method according to embodiments of the present invention. It can be correct for by applying the same or a similar ramp filter as used in conventional back projection algorithms. This means that in real space, $\Psi(\overline{R},z)$ is convoluted by the Fourier transform of the ramp filter $f(\overline{R})$ so that finally

$$\tilde{V}(\overline{R},z) = e^{-i\Delta z}(\psi(\overline{R},z) * f(\overline{R})) \qquad [22]$$

Note that since the back projection is not distributed homogeneously along z, the viewing directions that differ 180° are not equivalent.

Whereas the above has been worked out for electron tomography, it is also applicable to other fields of coherent optics. If one considers for example the case of X-ray tomography with a coherent source (e.g. synchrotron). The parabolic correction of the wave field, which describes the beam spreading as shown in FIG. 4, is important when

$$\varepsilon\lambda G^2 \rangle 1 \qquad [23]$$

where $\varepsilon$ is the distance over which the wave propagates.

If an object with average diameter d in all directions and a required resolution $\rho = \dfrac{1}{G}$ is considered, then the minimal requirement is

$$d\lambda \rangle \rho^2 \qquad [24]$$

Assuming that the number of pixels in all directions is N, then

$$d \approx N\rho \qquad [25]$$

and

$$\rho \langle N\lambda \qquad [26]$$

The interpretation is very simple. $\dfrac{\lambda}{\rho} = \theta$ is the maximal scattering angle and $d\theta$ is the parallax on viewing through the object, whereby the above equation requires that the parallax may not exceed one pixel. For typical X-ray imaging N = 2000, $\lambda$ =0.1$nm$ and $\rho\langle200nm$ which illustrates the advantages of using the tomographic reconstruction method for high resolution X-ray tomography.

In one aspect, the present invention also relates to a method for studying objects using coherent radiation tomography, such as for example x-ray tomography or electron tomography. The method is especially suitable for obtaining information regarding a type of objects, such as for example size information, information about the internal structure, etc., whereby a plurality of identical objects are available for study. Possible objects may for example be proteins, other small biological materials, nanoparticle like quantum dot, catalytic particles, etc. According to embodiments of the present invention, the method comprises receiving tomographic data of a substrate with a plurality of identical objects, which may be oriented in different directions. The substrate may be any suitable substrate, such as a thin film, preferably not interfering too much with the tomography results, i.e. advantageously not contributing too strong to the detected data, such that the date regarding the objects to be imaged is still predominantly present. The substrate may be a substrate with only a limited number of isolated objects, which are easy to locate and average, a substrate with many overlapping objects so as to improve the statistics or also possible a mixture of objects of different types. The method also may be repeatedly performed, e.g. first on a substrate comprising a small number of identical objects to allow easy identification and thereafter a substrate with a large number of identical objects for improving statistics. The tomographic data of the substrate with the plurality of identical objects may be obtained for the substrate being tilted over a plurality of angles, e.g. in a range of angles. Advantageously, the tomographic system on which the method is applied thus may comprise an accurate tilting system. The obtained tomographic data then is used for performing a method of reconstructing a tomographic image as described above, comprising similar features and having similar advantages as described above. The method furthermore may comprise deriving information regarding the type of particles by cross-correlating and averaging of the data, after reconstruction has been performed.

It is an advantage of embodiments according to the present invention that the method allows cryo electron microscopy imaging of individual particles, such as proteins, at the Angstrom level.

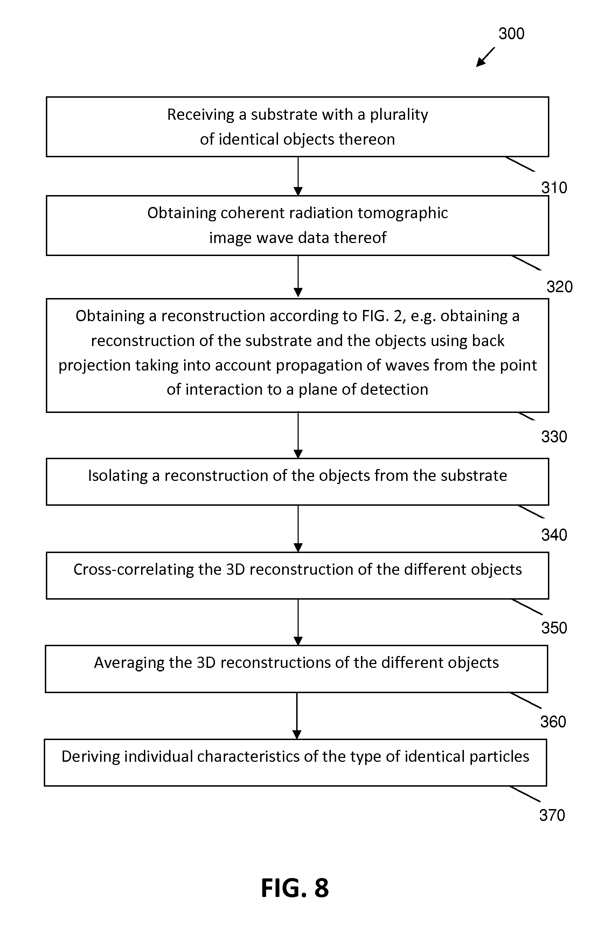

By way of illustration, embodiments of the present invention not being limited thereto, more detailed and other features and advantages of the method are illustrated with reference to an exemplary method 300 as shown in FIG.8.

The method 300 may comprise receiving 310 a substrate with a plurality of identical objects thereon. As described above, the substrate may be a thin film, although the invention is not limited thereto. Typical materials that may be used and that are not disturbing the object detection signals too significantly may for example be carbon films, although the invention is not limited thereto. The objects typically will be present in many orientations.

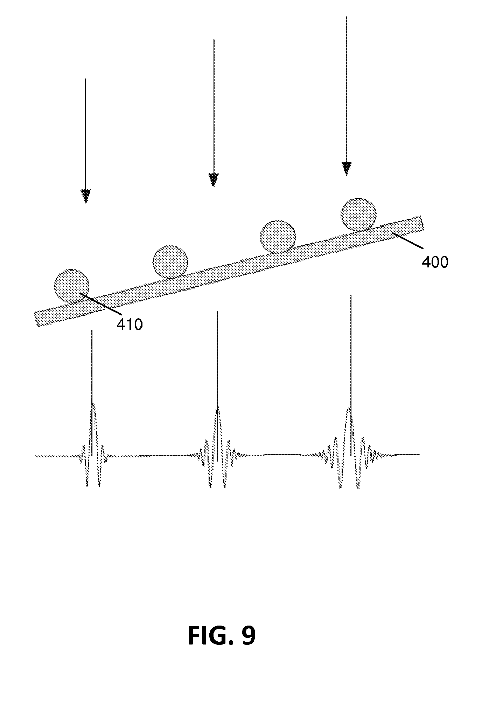

The method according to embodiments of the present invention comprises receiving, e.g. by obtaining through measurement or as data input via an input port, coherent radiation tomographic image wave data 320 from the substrate and the particles thereon. The data advantageously is recorded for different tilt positions of the substrate over a large range of angles, although the invention is not limited thereto. By tilting, a rough 3D reconstruction of the substrate and all objects will be obtained without having to determine first their position and orientation, resulting in a computational feasible method. The imaging may be performed using a system as described above. By way of illustration, a schematic example of imaging of a substrate with identical particles for one tilting angle is shown in FIG. 9, illustrating the substrate 400 and the objects 410 positioned thereon. Because of the dose fractionation theorem the total intensity, e.g. electron dose, can be divided over the whole tilt series so that the radiation damage of objects, e.g. proteins, will not be increased. Accurate tilting and positioning control may be applied. In some examples, an accuracy of about 0.1˚ for tilting and 1 Angström may be used, the invention not being limited thereto.

The method furthermore comprises obtaining a reconstruction 330 using a reconstruction method as described in the first aspect. Such a reconstruction method comprises obtaining a reconstruction of the substrate and the objects using back projection taking into account propagation of waves from the point of interaction to a plane of detection. On tilting the film, the focus changes continuously and differently for every position on the film. At the Angstrom level such change in focus has a strong effect on the tomographic data that can be obtained, for electron tomography e.g. on the phase transfer function of the EM, and thus on the resolution. Using the reconstruction method integrating wave propagation in the filtered back projection, the effect of changing imaging conditions during tilting are taken into account, even from position to position on the substrate, resulting in appropriate resolution levels obtained. In this way errors induced by the defocusing effects due to the spreading of the objects over the substrate and due to the different tilting angles used can be avoided in the reconstruction obtained. The resulting reconstruction may then further be used for extracting information, as shown below. Other features and advantages of the reconstruction step may be as set out for the reconstruction method in the first aspect.

Once the reconstruction is obtained, the method optionally may comprise isolating 340 a reconstruction of the different objects from the substrate. The latter allows to remove the substrate from the image, such that only information regarding the objects of interest is available.

Cross-correlation 350 may be performed after reconstruction to match the reconstruction of different identical objects with each other, such that averaging 360 can be performed. In this way, the resolution can be statistically increased, resulting in a high resolution detection technique. By averaging a large number of reconstructed objects, such as reconstructed proteins, one can then improve the resolution to the Angstrom level.

Cross-correlation and averaging techniques used may be conventional cross-correlation and averaging techniques. From the obtained averaged reconstructed type of object, individual characteristics of the type of identical particles under study can be derived.

Other features and advantages may be as known by the person skilled in the art.

In one aspect, embodiments of the present invention also relate to computer-implemented methods for performing at least part of the methods for reconstructing objects in coherent radiation tomography. Embodiments of the present invention also relate to corresponding computer program products. The methods may be implemented in a computing system. They may be implemented as software, as hardware or as a combination thereof. Such methods may be adapted for being performed on computer in an automated and/or automatic way. In case of implementation or partly implementation as software, such software may be adapted to run on suitable computer or computer platform, based on one or more processors. The software may be adapted for use with any suitable operating system such as for example a Windows operating system or Linux operating system. The computing means may comprise a processing means or processor for processing data. According to some embodiments, the processing means or processor may be adapted for performing reconstruction of objects according to any of the methods as described above or performing obtaining studying individual objects using coherent radiation tomography according to any of the methods as described above. The processor therefore may be adapted for applying back projection using propagation of waves from the point of interaction to a plane of detection. Besides a processor, the computing system furthermore may comprise a memory system including for example ROM or RAM, an output system such as for example a CD-rom or DVD drive or means for outputting information over a network. Conventional computer components such as for example a keybord, display, pointing device, input and output ports, etc also may be included. Data transport may be provided based on data busses. The memory of the computing system may comprise a set of instructions, which, when implemented on the computing system, result in implementation of part or all of the standard steps of the methods as set out above and optionally of the optional steps as set out above. By way of illustration, the present invention not being limited thereto, an exemplary flow schemes of computer implemented methods may be as shown in FIG. 2 and FIG. 8. The obtained results may be outputted through an output means such as for example a plotter, printer, display or as output data in electronic format.

Further aspect of embodiments of the present invention encompass computer program products embodied in a carrier medium carrying machine readable code for execution on a computing device, the computer program products as such as well as the data carrier such as dvd or cd-rom or memory device. Aspects of embodiments furthermore encompass the transmitting of a computer program product over a network, such as for example a local network or a wide area network, as well as the transmission signals corresponding therewith.

While the invention has been illustrated and described in detail in the drawings and foregoing description, such illustration and description are to be considered illustrative or exemplary and not restrictive. It will be appreciated, however, that no matter how detailed the foregoing appears in text, the invention may be practiced in many ways, and is therefore not limited to the embodiments disclosed.

Other variations to the disclosed embodiments can be understood and effected by those skilled in the art in practicing the claimed invention, from a study of the drawings, the disclosure and the appended claims. For example, whereas the present invention has mainly been described with reference to methods for reconstructing and for studying objects, embodiments of the present invention also relate to a tomography system comprising an image processing system, wherein the image processing system is adapted for performing any of the methods according to the present invention. According to one embodiment, a tomography system is provided comprising an image processing system, the processing system comprising a back projector for performing back-projecting comprising propagating waves from the point of interaction to a plane of detection. The image processing system furthermore may comprise components for performing the functionality of basic and optional steps of the methods as described above.

In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage.

Any reference signs in the claims should not be construed as limiting the scope.

It should be noted that the use of particular terminology when describing certain features or aspects of the invention should not be taken to imply that the terminology is being re-defined herein to be restricted to include any specific characteristics of the features or aspects of the invention with which that terminology is associated.

## Claims

1.  A method for reconstructing a coherent radiation tomographic image of at least one object, the method comprising performing back-projecting, whereby said performing back-projecting comprises taking into account propagation waves from the interaction volume to a detection surface.

2.  A method according to claim 1, wherein the method comprises

    - receiving image wave tomographic data.

3.  A method according to any of the previous claims, wherein the image wave tomographic data comprises X-ray wave tomographic data or electron microscopy wave tomographic data.

4.  A method according to any of the previous claims, wherein the method furthermore comprises applying a ramp filter for correcting for oversampling of an origin of the object imaged.

5. A method according to any of the previous claims, wherein the back-projecting comprises Fourier transforming projected image wave tomographic data thus back-propagating from the image plane to the object.

6. A method according to any of the previous claims, wherein performing back-projecting comprises sectioning a Fourier space in paraboloids.

7. A method according to any of the previous claims, wherein the method furthermore comprises applying a Wiener filter for taking into account scattering.

8. A method for studying objects using coherent radiation tomography, the method comprising

   - receiving tomographic data of a substrate with a plurality of identical objects, and
   - applying a method for reconstructing a tomographic image according to any of claims 1 to 7 based on said received tomographic data.

9. A method according to claim 8, wherein the tomographic data of the substrate with the plurality of identical objects comprises data for the substrate being relatively tilted over a range of angles with respect to the radiation used.

10. A method according to any of claims 8 to 9, the method further comprising isolating a 3D reconstruction of the particles from the substrate.

11. A method according to any of claims 8 to 10, the method further comprising performing cross-correlation of the plurality of objects in the reconstruction so as to derive individual information of the identical particles under study by averaging.

12. An image processing system configured for performing a method for reconstructing a coherent radiation tomographic image of at least one object according to any of claims 1 to 7, or performing a method for studying objects using coherent radiation tomography according to any of claims 8 to 11.

13. A tomography device for performing tomography, the system comprising an image processing system according to claim 12.

14. A computer program product for performing, when implemented on a computing device, a method according to any of claims 1 to 11.

15. Use of a method according to any of claims 1 to 11 for characterisation of proteins using electron tomography.

**FIG. 1**

EP 2 309 459 A1

100

### Receiving tomographic image wave data

110

### Back projecting using image wave tomographic data

Identifying projected image wave data in tomographic data

130

Optionally convoluting projection data with ramp filter

140

Back projecting taking into account the propagation vector

150

Combining resulting back projections for object reconstruction

140

160

## FIG. 2

14

**FIG. 3**

**FIG. 4**

$e_z$

$f(\mathbf{R})$

$f_p(\mathbf{R})$

real space

$F(\mathbf{G})$

$F(\mathbf{G},0)$

Fourier space

# FIG. 5

real space

Fourier space

$FT^{-1}$

# FIG. 6

**FIG. 7**

300

Receiving a substrate with a plurality
of identical objects thereon

310

Obtaining coherent radiation tomographic
image wave data thereof

320

Obtaining a reconstruction according to FIG. 2, e.g. obtaining a
reconstruction of the substrate and the objects using back
projection taking into account propagation of waves from the point
of interaction to a plane of detection

330

Isolating a reconstruction of the objects from the substrate

340

Cross-correlating the 3D reconstruction of the different objects

350

Averaging the 3D reconstructions of the different objects

360

Deriving individual characteristics of the type of identical particles

370

**FIG. 8**

**FIG. 9**

Europäisches
Patentamt

European
Patent Office

Office européen
des brevets

## EUROPEAN SEARCH REPORT

Application Number

EP 09 17 0779

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DEVANEY A ET AL: "Optical diffraction tomography in an inhomogeneous background medium" MEASUREMENT SCIENCE AND TECHNOLOGY, IOP, BRISTOL, GB, vol. 19, no. 8, 1 August 2008 (2008-08-01), page 85505, XP020144360 ISSN: 0957-0233 | 1-5,7-15 | INV. G06T11/00 H01J37/22 |
| Y | * the whole document * & DEVANEY ET AL: "A filtered backpropagation algorithm for diffraction tomography" ULTRASONIC IMAGING, DYNAMEDIA INC., SILVER SPRING, MD, US, vol. 4, no. 4, 1 October 1982 (1982-10-01), pages 336-350, XP023046334 ISSN: 0161-7346 [retrieved on 1982-10-01] * figure 5; table 1 * ----- | 6 | |
| Y | DYCK D VAN ET AL: "A NEW APPROACH TO OBJECT WAVEFUNCTION RECONSTRUCTION IN ELECTRON MICROSCOPY" OPTIK, WISSENSCHAFTLICHE VERLAG GMBH.STUTTGART, vol. 93, no. 3, 1 May 1993 (1993-05-01), pages 103-107, XP000364883 ISSN: 0030-4026 * page 104, right-hand column; figure 1 * ----- | 6 | TECHNICAL FIELDS SEARCHED (IPC) G06T H01J |
| A | JIANG HUA CHEN ET AL: "Accurate multislice theory for elastic electron scattering in transmission electron microscopy" ULTRAMICROSCOPY ELSEVIER NETHERLANDS, vol. 70, no. 1-2, December 1997 (1997-12), pages 29-44, XP007911886 ISSN: 0304-3991 * the whole document * ----- | 1-15 | |

The present search report has been drawn up for all claims

| Place of search | Date of completion of the search | Examiner |
|---|---|---|
| Munich | 25 February 2010 | Werling, Alexander |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)